# EUROPÄISCHE PATENTSCHRIFT

(11) **EP 2 008 443 B1**
(45) Veröffentlichungstag und Bekanntmachung des Hinweises auf die Patenterteilung: **13.06.2012**
(21) Anmeldenummer: 07704148.1
(22) Anmeldetag: 26.01.2007
(51) Int. Cl.: H04N 5/225, H01L 27/146

(54) **VERFAHREN ZUR MONTAGE EINES KAMERAMODULS UND KAMERAMODUL**
METHOD FOR ASSEMBLING A CAMERA MODULE, AND CAMERA MODULE
PROCEDE POUR LE MONTAGE D'UN MODULE DE CAMERA ET MODULE DE CAMERA

(30) Priorität: 22.03.2006 DE 102006013164
(43) Veröffentlichungstag der Anmeldung: 31.12.2008
(73) Patentinhaber: Robert Bosch GmbH, 70442 Stuttgart (DE)
(72) Erfinder: APEL, Uwe, 72666 Neckartailfingen (DE)
(86) Internationale Anmeldenummer: PCT/EP2007/050755
(87) Internationale Veröffentlichungsnummer: WO 2007/107392

(56) Entgegenhaltungen:
- EP-A- 1 498 756
- WO-A-2005/031422
- US-A1- 2002 154 239
- US-A1- 2005 168 846
- US-A1- 2005 185 088
- US-A1- 2005 237 415

## Beschreibung

### Stand der Technik

In Fahrzeugen kommen heute zunehmend Kameramodule zum Einsatz, so zur Applikation in Night-Vision-Systemen oder als LDW (Lane Departure Waming)-Systeme. An solchen Kameras werden hinsichtlich ihres Einbaus im Fahrzeug besondere Anforderungen hinsichtlich der Robustheit, angesichts der im Betrieb unvermeidlich auftretenden Erschütterungen gestellt.

Für die Montage von Kameramodulen für Fahrzeuge sind zwei grundlegend unterschiedliche Ansätze bekannt: Es wird ein Imager-Modul eingesetzt, welches einen Bild-Sensor-Chip, ein Basisgehäuse und ein Objektiv umfasst, wobei das Objektiv als eigenständiges Modul gefertigt und getestet wird. Derartige Imaging-Module können z. B. durch thermisches Fügen, wie z. B. durch Lötverfahren oder mittels eines Kabelendes mit Stecker, an die Leiterplatte angebunden werden. Anschließend wird die derart komplettierte Leiterplatte in das Gehäuse montiert, das eine entsprechende Aufnahme für das Objektiv aufweisen muss. Nachteilig bei dieser Vorgehensweise ist der Umstand, dass Imager-Module mit für Kfz-Anwendungen geeigneten Chip- und Objektivabmessungen in den gängigen Lötverfahren - so z. B. Reflowverfahren - nicht sicher zu fertigen sind. Es können sich aufgrund der hohen Wärmekapazität schlechte Lötverbindungsstellungen ausbilden oder eine Schädigung der Optik auftreten. Zum anderen sind die als Alternativlösungen bekannten Steckerkontakte im Fahrzeug nicht langfristig fehlerfrei. Als problematisch hat sich ferner die Abdichtung des gesamten Kameramoduls bei einem Aufbau der Leiterplatte mit Imager-Modul herausgestellt, da häufig mechanische Verspannungen auftreten, die auf das Imager-Modul wirken, was zu Folgeschäden führen kann.

Ein weiteres Montagekonzept basiert auf dem Aufbau der Leiterplatte mit einem eigenständig verpackten Bildsensor, wobei es sich typischerweise um ein Keramikgehäuse mit Glasdeckel handelt. Damit kann das empfindliche Pixelarray ausreichend gegen Partikel geschützt werden. Ferner sind derartige Gehäuse in Reflow-Prozessen verarbeitbar. Das Objektiv kann entweder in einem auf der Leiterplatte befestigten Linsenhalter fokussiert werden oder in der Gehäuseschale des Kameramoduls. Dieser Ansatz weist jedoch eine recht lange Toleranzkette aufgrund der höheren Anzahl von zu verbauenden Einzelkomponenten auf, was nach Montage im ungünstigsten Falle durch Addition der größten Toleranzen zu ungenau arbeitenden Kameramodulen führen kann.

Aus DE 10 2004 001 698 A1 ist ein optisches Modul bekannt. Gemäß dieser Lösung umfasst ein optisches Modul einen aus optischen und elektronischen Komponenten bestehenden Bildaufnehmer, wobei die Komponenten des Bildaufnehmers gemeinsam auf einer Trägerplatte angeordnet sind. Die Komponenten des Bildaufnehmers sind auf einer ersten Hauptfläche der Trägerplatte angeordnet, wobei eine dem Bildaufnehmer zugeordnete Optik auf einer zweiten Hauptfläche der Trägerplatte angeordnet ist. Die Trägerplatte und die Optik sind in eine Vergussmasse eingebettet. Das optisches Modul umfasst ein Halteelement für die Befestigung des optischen Moduls an einem Fahrzeugteil oder dergleichen. Das Halteelement ist mit dem optischen Modul vergossen, wobei das optische Modul eine Abschirmung gegen elektromagnetische Störstrahlung umfasst. Auch die Abschirmung kann gemäß dieser Lösung in die Vergussmasse eingebettet sein. Die Abschirmung wird bevorzugt als ein in die Vergussmasse eingebettetes Netz oder Gitter ausgebildet oder kann aus in die Vergussmasse eingebetteten Partikeln bestehen.

### Offenbarung der Erfindung

Der Erfindung liegt die Aufgabe zugrunde, ein für Kraftfahrzeuganwendungen geeignetes Kameramodul, welches möglichst wenig Unterkomponenten beinhaltet, bereitzustellen, bei dem bereits während der Montage eine Fokussierung zwischen einem Bildsensor-Chip und dem Objektiv des Kameramoduls erhalten wird.

Erfindungsgemäß wird diese Aufgabe dadurch gelöst, dass entweder leiterplattenseitig oder gehäuseseitig mindestens ein hülsenförmiges Passungsteil vorgesehen ist, welches aus einem Kunststoff gefertigt ist, der sich durch eine lokale Erwärmung schnell und in begrenztem Bereich aufschmelzen lässt und so mit einem zu diesem Passungsteil komplementären weiteren Passungsteil stoffschlüssig verbunden werden kann.

Bevorzugt werden in dem erfindungsgemäß vorgeschlagenen Verfahren zur Herstellung eines Kameramoduls ein gehäuseseitiges erstes Passungsteil und ein leiterplattenseitiges zweites Passungsteil eingesetzt, die bei der Montage teleskopartig ineinander greifen. Die Passungsteile aus einem Kunststoffmaterial können sowohl als Hülsen als auch als quaderförmige Körper oder in einer beliebigen anderen Geometrie ausgebildet sein; allein beim Fügen der beiden Passungsteile ist dafür Sorge zu tragen, dass sich ein Überlappungsbereich zwischen dem ersten Passungsteil und dem zweiten Passungsteil einstellt. Wenigstens eines der beiden bevorzugt eingesetzten Passungsteile wird mit mindestens einer elektrisch leitfähigen Windung beschichtet, durch welche ein Stromimpuls geleitet werden kann, der zu einem lokalen Aufschmelzen des besagten Passungsteils, bevorzugt an dessen äußerer Mantelfläche führt. Alternativ kann ein Anschmelzen einer Innenseite eines der beiden bevorzugt eingesetzten Passungsteile erzeugt werden.

Anschlüsse der für das Aufschmelzen verwendeten Leiterbahnen können entweder an einer Gehäuseschale des Kameramoduls oder an der Leiterplatte derart herausgeführt werden, dass sie während des Fokussierprozesses kontaktiert werden können. Die Fokussierung erfolgt mittels aktiver Bildauslesung und Bildauswertung sowie motorischer Ausrichtung der miteinander zu fügenden Komponenten, in der Regel einem Gehäuseteil und einer vormontierten beziehungsweise vorbestückten Leiterplatte. Nach Durchführung der Fokussierung wird durch die Leiterbahnen, die an einem der beiden Passungsteile in Form einer Beschichtung aufgetragen sind, ein Stromimpuls aufgegeben, der durch das Aufschmelzen des Kunststoffmaterials eine Verklebung und damit eine stoffschlüssige Verbindung herbeiführt, wodurch eine stabile Verbindung der beiden Passungsteile miteinander erzeugt wird.

Die Oberflächen der ineinander greifenden Passungsteile können so texturiert werden, dass eine standfeste Verbindung mit minimaler Einwirkdauer und Leistung des Strompulses erreichbar ist.

Ein derart gefertigtes Kameramodul, insbesondere zum Einsatz bei Anwendungen im Automobilbereich, bietet unter anderem den Vorteil, dass der Bildsensor-Chip durch Verwendung eines insbesondere videounterstützten Die-Bonding-Prozesses direkt mit hoher Präzision zu Referenzlöchern, die in der Leiterplatte ausgebildet sind, positioniert werden kann. Ablagefehler, die bei separat untergebrachten Bildsensor-Chips entstehen, werden somit vermieden. Das der Leiterplatte bevorzugt zugeordnete der beiden Passungsteile kann in einer Anzahl von Referenzbohrungen, die z. B. in einer 120°-Teilung an der Leiterplatte vorgesehen werden, passgenau innerhalb eines Aufsetzbereiches fixiert werden.

Bei Einsatz eines Leiterplatten-Fertigungsprozesses, bei dem z. B. SMD-Bauteile auf der Leiterplatte verlötet werden können, kann der Bildsensor-Chip direkt nach dem Drahtbonden durch das mit einer Membran verschlossene Passungsteil abgedeckt und so vor Partikeln, die im Herstellungsprozess unvermeidlich auftreten, geschützt werden. Da der hochempfindliche Bildsensor-Chip somit vor Partikelbefall beziehungsweise Partikelanlagerung geschützt ist, können alle weiteren Prozess-, Test- und Transportschritte bis zum Verbau in das Gehäuse des Kameramoduls in einer beliebigen Fertigungsumgebung erfolgen. Wird die Membran z. B. auf dem außen liegenden Passungsteil mit dem größeren Durchmesser aufgeklebt, wird ein unbeabsichtigtes Verbleiben der Membran oder einer Folie auf diesem vor der Fokussierung ausgeschlossen.

Die bevorzugt eingesetzten zwei Passungsteile werden so ausgelegt, dass die Tragefunktion der Leiterplatte mit übernommen werden kann. Erfolgt die Anbindung der Leiterplatte an dem gehäuseseitigen Kontaktstecker mit einem flexiblen Medium, wie z. B. einem Flex Cable oder Floating-Steckverbindern, können Spannungsbelastungen in der Leiterplatte durch Mehrfacheinspannung vermieden werden.

Die z. B. hülsenförmig ausbildbaren Passungsteile können in einem für die optischen Anforderungen geeigneten Material angefertigt werden, so dass sich sehr niedrige Reflexionswerte einstellen und damit das Risiko optischer Störungen durch Streulicht erheblich herabgesetzt wird.

Ein weiterer zu nennender Vorteil ist, dass das Objektiv dicht in die Gehäuseschale des Kameramoduls integriert werden kann, so dass ein anschließender Abdichtungsprozessschritt entfallen kann.

Die Fixierung der im Rahmen der Fokussierung genau eingestellten Fokuslage kann durch den elektrisch steuerbaren, lokalen Aufschmelzprozess sehr schnell ausgeführt werden. Im Gegensatz zum Laserschweißen oder zur UV-Härtung stellen sich keine Probleme ein, da für die Aktivierung der Verklebung beziehungsweise Verschmelzung die erforderliche Energie im Vergleich zum Laserschweißen und UV-Härtung relativ gering ist.

Ferner lässt sich eine Bauteileinsparung dadurch erzielen, dass die Differenzierung von Kameras mit unterschiedlicher Auslegung, d. h. unterschiedlich konfiguriertem Objektiv, aber gleichem elektronischen Aufbau vereinfacht werden kann, da lediglich das das Objektiv aufnehmende Gehäuseteil verändert werden muss, wohingegen die vormontierte beziehungsweise vorbestückte Leiterplatte ein Gleichteil sein kann.

### Zeichnung

Anhand der Zeichnung wird die Erfindung nachstehend eingehender beschrieben.

Es zeigt:
- Figur 1: eine Draufsicht auf die vormontierte beziehungsweise vorbestückte Leiterplatte eines erfindungsgemäß vorgeschlagenen Kameramoduls,
- Figur 2: einen Schnitt durch die Leiterplatte gemäß des Schnittverlaufes II-II in Figur 1 mit Schnitt durch die in Figur 1 nicht dargestellte Gehäuseschale des Kameramoduls,
- Figur 3: eine Explosionszeichnung der Komponenten eines Kameramoduls mit zylindrischen, zueinander komplementär ausgebildeten Passungsteilen und
- Figur 4: eine Explosionszeichnung einer Ausführungsvariante des erfindungsgemäß vorgeschlagenen Kameramoduls mit rechteckförmig konfigurierten, zueinander komplementär ausgebildeten Passungsteilen.

### Ausführungsvarianten

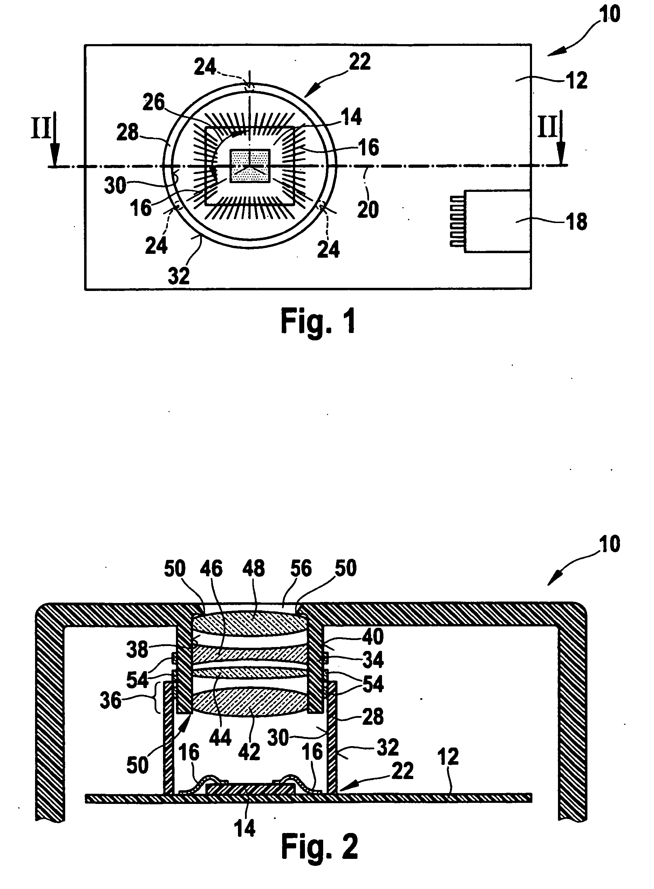

Der Darstellung gemäß Figur 1 ist die Draufsicht auf eine vormontierte beziehungsweise vorbestückte Leiterplatte des erfindungsgemäß vorgeschlagenen Kameramoduls zu entnehmen.

Von einem in Figur 1 nicht dargestellten Gehäuse ist eine Leiterplatte 12 eines Kameramoduls 10 umschlossen. Auf der Leiterplatte 12 befindet sich ein Bildsensor-Chip 14, der im Wege des Chip-On-Board-Verfahrens (COB) direkt auf der Leiterplatte 12 montiert wird. Auf der Leiterplatte 12 sind auch andere, in Figur 1 nicht näher dargestellte elektronische Komponenten des Kameramoduls 10 aufgenommen. Die Ausrichtung des Bildsensor-Chips 14 wird bevorzugt durch Videounterstützung mit Bezug auf in der Leiterplatte 12 in einer 120°-Teilung 26 in Bezug aufeinander positionierte Referenzöffnungen 24 vorgenommen. Die elektrische Anbindung der Leiterplatte 12 erfolgt bevorzugt über ein Anschlussteil 18, in welches flexible Verbindungselemente, z. B. Flat Flexible Cables oder dergleichen oder eine geeignete Steckerlösung, eingeführt werden, so dass Toleranzen im mechanischen Aufbau des Kameramoduls 10 spannungsfrei ausgeglichen werden können. Mit einem geeigneten Leiterplattenfertigungsprozess können die elektronischen Komponenten, bei denen es sich beispielsweise um SMD-Bauteile handeln kann, und der Bildsensor-Chip. 14 über Kontaktierungen 16 beispielsweise mit der Leiterplatte 12 verlötet. Die in Figur 1 dargestellten, in einer hier 120° betragenden Teilung 26 angebrachten Referenzöffnungen 24 sind innerhalb eines Aufsetzbereichs 22 angeordnet, in dessen Bereich ein erstes z. B. hülsenförmig ausgebildetes Passungsteil 28 mit der Leiterplatte 12 stoffschlüssig, z. B. durch Verkleben, verbunden wird. Dazu weist das erste Passungsteil 28 an seiner in Figur 1 nicht dargestellten Unterseite eine zur Anzahl der Referenzöffungen 24 korrespondierende Anzahl von Passstiften oder Passzapfen auf. Die Symmetrieachse der Leiterplatte 12 ist in der Darstellung gemäß Figur 1 durch Bezugszeichen 20 bezeichnet. Das in der Darstellung gemäß Figur 1 hülsenförmig ausgebildete erste Passungsteil 28 umfasst eine Innenfläche 30 sowie eine Außenfläche 32. Aus der Darstellung gemäß Figur 1 geht hervor, dass das innerhalb des Aufsetzbereiches 22 montierte erste Passungsteil 28 den Bildsensor-Chip 14 umschließt.

Figur 2 zeigt einen Schnitt durch die Leiterplatte gemäß der Darstellung in Figur 1 gemäß des Schnittverlaufes II-II.

Die Leiterplatte 12, auf welcher der Bildsensor-Chip 14 bevorzugt mittels des Chip-On-Board-Verfahrens (COB) über Kontaktierungen 16 verbunden ist, wird von einer Gehäuseschale des Kameramoduls 10 umschlossen. Während an der Oberseite der Leiterplatte 12 das erste Passungsteil 28 - hier hülsenförmig ausgebildet - im Bereich des Aufsetzbereiches 22 mit der Leiterplatte 12 verstiftet und stoffschlüssig verbunden ist, befindet sich an der der Leiterplatte 12 zuweisenden Innenseite der Gehäuseschale des Kameramoduls 10 ein weiteres, zweites Passungsteil 34. Das erste leiterplattenseitige Passungsteil 28 und das zweite, gehäuseseitige Passungsteil 34 sind komplementär zueinander ausgebildet, so dass beim Fügen der Leiterplatte 12 mit dem Gehäuse des kameramoduls 10 ein Überlappungsbereich 36 entsteht, d. h. ein Bereich, innerhalb dessen das zweite Passungsteil 34 in das erste Passungsteil 28 hineinragt. Das komplementär zum ersten Passungsteil 28 ausgebildete, zweite Passungsteil 34 bildet einen Tubus 52, in dem ein Objektiv 42 aufgenommen ist. In dem Objektiv 42 können sich im zweiten Passungsteil 34 beispielsweise eine erste Linse 44 sowie eine konkave Linse 46 sowie eine konvexe Linse 48 befinden, je nach Applikationszweck des Kameramoduls 10. Neben einer zylindrischen Ausbildung der ersten und zweiten Passungsteile 28 beziehungsweise 34 können diese auch rechteckförmig, quaderförmig oder in einer anderen Geometrie ausgebildet sein, wobei die Geometrien des ersten und des zweiten Passungsteiles 28 beziehungsweise 34 so aufeinander abgestimmt sind, dass sich beim Fügen der in Figur 2 dargestellte Überlappungsbereich 36 einstellt. Während das erste Passungsteil 28 mit der Leiterplatte 12 stoffschlüssig verbunden sein kann der mit der Leiterplatte 12 verstiftet ist, kann das erste Passungsteil 34 integraler Bestandteil des Gehäuses des Kameramoduls 10 sein, so z. B. an dieses angespritzt sein. Das erste Passungsteil 28 bildet ein mechanisches Verbindungselement zwischen der Leiterplatte 12 und dem Gehäuse des Kameramoduls 10 und schützt den Bildsensor-Chip 14 gegen Partikel. Die korrekte Positionierung wird durch die in die Referenzöffnungen 24 in der Leiterplatte 12 einsteckbaren Führungsbolzen erreicht.

Das Objektiv 42 ist in geeigneter Weise in dem Gehäuse des Kameramoduls 10 vormontiert. Dadurch bietet sich die Möglichkeit, Kameramodule 10 mit unterschiedlichen optischen Auslegungen basierend auf der gleichen Elektronik herzustellen, da bei verschiedenen Gehäusen mit verschiedenen Objektive unter Zugrundelegung des Gleichteileprinzip identisch bestückte Leiterplatten 12 Verwendung finden können. Entweder mit dem Gehäuse einstückig ausgebildet oder mit dem Gehäuse des Kameramoduls 10 verbunden ist das zweite Passungsteil 34 derart ausgelegt, dass es eine erste Fokussierung zwischen dem Objektiv 42 und dem Bildsensor-Chip 14 erlaubt.

Wenigstens eines der in Figur 2 dargestellten Passungsteile 28 beziehungsweise 34 wird bevorzugt aus einem Kunststoff gefertigt, der sich durch eine lokale Erwärmung schnell und in begrenztem Bereich auf- oder anschmelzen lässt und so mit einen Gegenstück verschweißen oder verkleben lässt. Dazu wird wenigstens eines der beiden in Figur 2 dargestellten, hülsenförmig ausgebildeten Passungsteile 28, 34, die innerhalb des Überlappungsbereiches 36 ineinander greifen, mit mindestens einer elektrisch leitfähigen Leiterbahn 54 z. B. beschichtet. Durch die mindestens eine Leiterbahn 54 - hier aufgebracht an der Außenfläche 40 des zweiten Passungsteiles 34 - kann ein Stromimpuls geleitet werden, der zum lokalen Aufschmelzen führt. Die Leiterbahnen 54, die zum An- oder Aufschmelzen des Kunststoffmaterials verwendet werden, können entweder an dem Gehäuse des Kameramoduls 10 oder an der Leiterplatte 12 so herausgeführt werden, dass sie während des Fokussierprozesses, d. h. der Ausrichtung zwischen dem Bildsensor-Chip 14 relativ zum Objektiv 42, elektrisch kontaktiert werden können. Die Fokussierung des Bildsensor-Chips 14 und des Objektivs 20 zueinander erfolgt mittels aktiver Bildauslesung und Bildauswertung und motorischer Ausrichtung der miteinander zu fügenden Komponenten, d. h. des Gehäuses des Kameramoduls 10 und der vormontierten Leiterplatte 12. Die Fokussierung erfolgt bei aktivem Betrieb des Bildsensor-Chips 14 mit Auswertung des Bilds des einen entsprechenden Test-Charts. Die einmal eingestellte Fokuslage wird bevorzugt durch einen möglichen Prozessschritt, wie z. B. dem lokalen Aufschmelzen des Kunststoffmaterials, mindestens eines der beiden Passungsteile 28, 34 sichergestellt. Die eingestellte Fokuslage ist sowohl gegenüber Temperaturänderungen als auch gegenüber Alterungsprozessen unempfindlich.

Nach Abschluss der Fokussierung wird die mindestens eine Leiterbahn 54 an der Außenfläche 40 des zweiten Passungsteils 34 mit einem Stromimpuls beaufschlagt, der durch das Aufschmelzen des Kunststoffes eine stoffschlüssige Verbindung, wie z. B. eine Verklebung, zwischen dem ersten Passungsteil 28 und dem zweiten Passungsteil 34 innerhalb des Überlappungsbereiches 36 zwischen der Innenfläche 30 des ersten Passungsteils 28 und der Außenfläche 40 des zweiten Passungsteils 34 erzeugt.

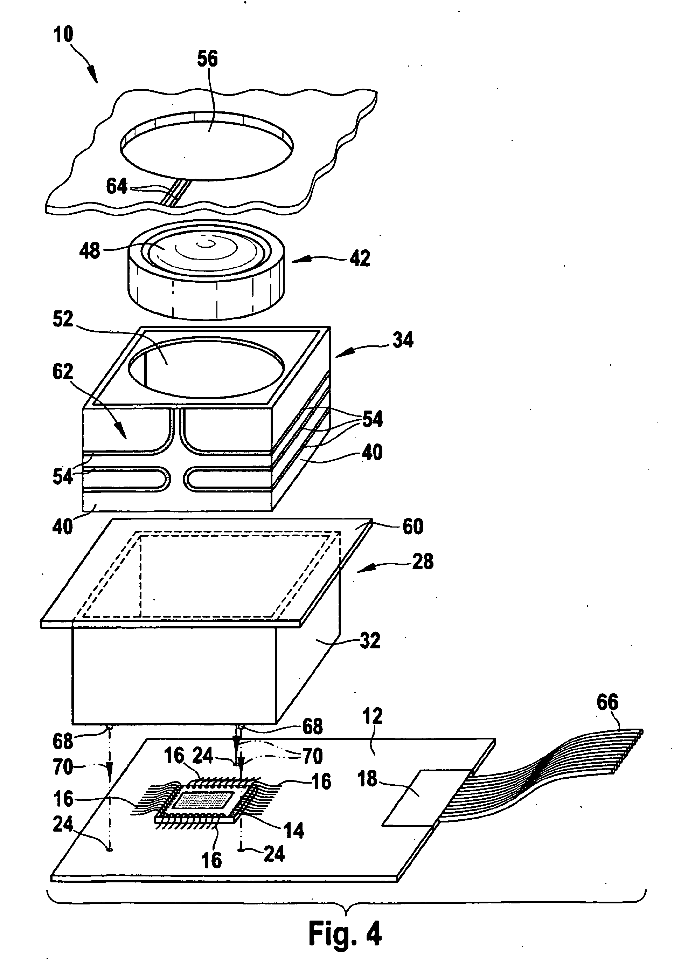

Die einander zuweisenden Oberflächen des ersten Passungsteils 28 und des zweiten Passungsteils 34 können derart texturiert sein, dass eine standfeste Verbindung bei minimaler Einwirkdauer des Stromimpulses und Leistung des Strompulses erreicht werden kann. Bei der Fokussierung durch den Überlappungsbereich 36 des ersten Passungsteiles 28 und des zweiten Passungsteiles 34 wird gewährleistet, dass ein Verkippen und eine daraus resultierende ungleiche Schärfeverteilung minimiert wird. Werden das erste Passungsteil 28 und das zweite Passungsteil 34 als zylindrische Hülsen ausgebildet, kann ein Ausgleich im Azimutwinkel erfolgen, was bei einer rechteckförmigen oder quaderförmigen Auslegung des ersten Passungsteils 28 und des zweiten Passungsteils 34 nur in begrenztem Rahmen möglich ist (vergleiche Figur 4).

Die Fokussierung kann mittels einer motorisierten, möglichst automatisierten Einrichtung vorgenommen werden, auf der die beiden Teilbaugruppen, d. h. das Gehäuse des Kameramoduls 10 und die vormontierte beziehungsweise vorbestückte Leiterplatte 12, durch Übereinanderschieben der beiden Passungsteile 28, 34 derart eingerichtet wird, dass die in den Bilddaten ermittelten Kontrastwerte der aufgenommenen Test-Charts optimiert sind. Nach Einstellung der Fokussierung zwischen dem Bildsensor-Chip 14 und dem Objektiv 42 werden die beiden Passungsteile 28, 34 gegeneinander fixiert. Neben dem erwähnten Beaufschlagen mit einem Stromimpuls der mindestens einen Leiterbahn 54 an einem der beiden miteinander zu fügenden Passungsteile 28, 34 können auch Prozessschritte, wie das Verstemmen, ein Verkleben oder auch durch UV-Aushärtung beschleunigte Verfahren, Schweißen, Klemmen oder auch Laserschweißen, eingesetzt werden.

Die innerhalb des Überlappungsbereiches 36 liegende stoffschlüssige Fügestelle ist im vorgeschlagenen Verfahren mit den hülsenförmig ausgebildeten Passungsteilen 28, 34 typischerweise durch die Leiterplatte 12 und das Gehäuse des Kameramoduls 10 abgedeckt und daher schlecht zugänglich. In einer Ausführungsvariante der Passungsteile 28, 34 kann die Außenfläche 32 des ersten zylindrischen, innenliegenden Passungsteiles 28 gerinfügig tonnenförmig (ballig) geformt werden. Damit entsteht für die Fokussierung zusätzlich zum Ausgleich eines eventuellen Azimutfehlers ein Freiheitsgrad zum Ausgleich sich eventuell einstellender Verkippungsfehler. Liegt die Oberfläche des Bildsensor-Chips 14 nicht in der Ebene der scharfen Abbildung, sondern verkippt dazu, kann die optimale Bildschärfe nicht auf dem gesamten Bildfeld gleichzeitig eingestellt werden. Bei Objektiven 42 mit großen Blendenöffnungen, wie sie z. B. für Nachtsichteinsatz eingesetzt werden, kann schon durch geringe Verkippungsfehler eine erkennbare Reduzierung der Bildqualität beobachtet werden.

Die Fokussierung eines Systems mit diesem zusätzlichen Freiheitsgrad zum Ausgleich von eventuellen Verkippungsfehlern erfordert eine spezielle Anlagentechnik, da die Fokussierung unter Berücksichtigung des Wankwinkels sowie sich einstellender Nick-und Gierwinkel durchzuführen ist.

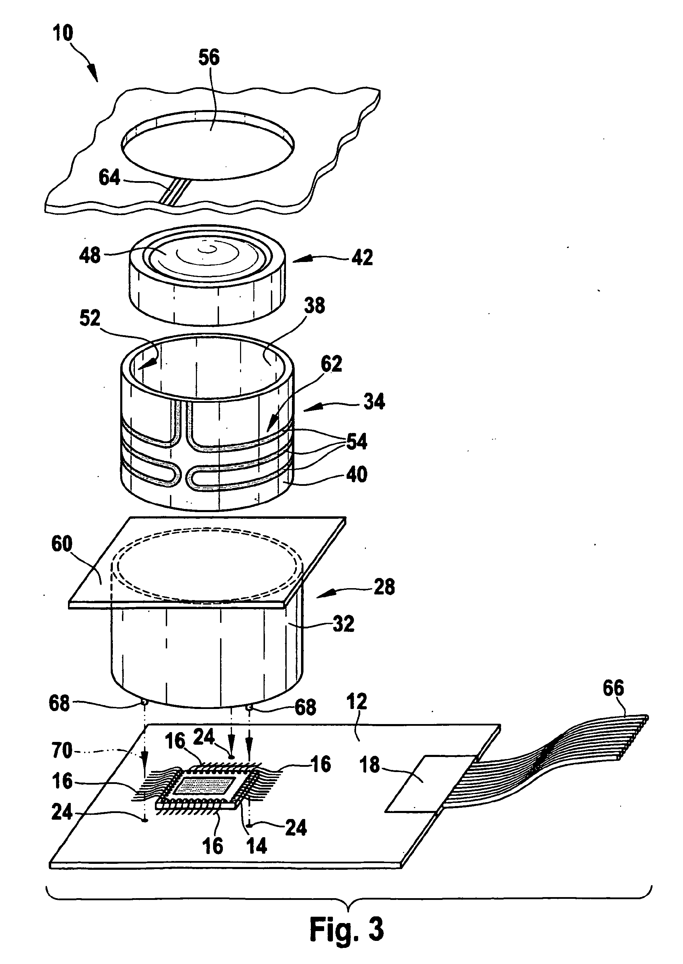

Der Darstellung gemäß Figur 3 ist eine Explosionsdarstellung eines erfindungsgemäß vorgeschlagenen Kameramoduls zu entnehmen, bei dem die zueinander komplementär ausgebildeten Passungsteile hülsenförmig ausgebildet sind.

Aus der Explosionsdarstellung gemäß Figur 3 geht hervor, dass der Bildsensor-Chip 14 über die Kontaktierungen 16 mit der hier schematisch dargestellten Leiterplatte 12 elektrisch verbunden ist. In einem Winkel von 120° versetzt zueinander sind in die Leiterplatte 12 die Referenzöffnungen 24 eingebracht (vergleiche Darstellung gemäß Figur 1). Das erste Passungsteil 28 weist an seiner unteren Ringfläche eine der Anzahl der Referenzöffnungen 24 entsprechende Anzahl von Passstiften 68 auf, die in der in Figur 3 dargestellten Fügerichtung 70 in die Referenzöffnungen 24 eingesteckt werden. Nach Ausbildung einer stoffschlüssigen Verbindung zwischen der unteren Randfläche des ersten Passungsteils 28 und der Oberseite der vormontierten beziehungsweise vorbestückten Leiterplatte 12 ist der an der Oberseite der Leiterplatte 12 aufgenommene Bildsensor-Chip 14 vom ersten Passungsteil 28 umgeben. Nach Montage des ersten Passungsteils 28 auf der Leiterplatte 12 wird das obere Ende des ersten hülsenförmig ausgebildeten Passungsteils 28 durch eine Membran 60 verschlossen. Damit ist der an der Oberseite der Leiterplatte 12 aufgenommene Bildsensor-Chip 14 vor Partikeln geschützt. Somit können alle weiteren Prozess-, Test- und Transportschritte bis zum Verbau der mit dem ersten Passungsteil 28 versehenen Leiterplatte 12 im Gehäuse des Kameramoduls 10 in beliebiger Fertigungsumgebung erfolgen. Wird die Membran 60 auf der Oberseite des ersten Passungsteils 28 aufgeklebt, kann verhindert werden, dass das Abnehmen der Membran 60 vor der Fokussierung zwischen dem Objektiv 42 des Kameramoduls 10 und dem Bildsensor-Chip 14 vergessen wird.

Der Darstellung gemäß Figur 3 ist ferner entnehmbar, dass das Anschlussteil 18 über ein flexibles Kabelende 66 erfolgt. Wird die elektrische Anbindung der Leiterplatte 12 an einem gehäuseseitigen Stecker mit einer flexiblen Lösung, wie in Figur 3 dargestellt, ausgeführt, können Spannungsbelastungen in der Leiterplatte 12 durch Mehrfacheinspannung vermieden werden.

Die Aufsetzrichtung, in der das erste Passungsteil 28 mit den an der Unterseite ausgebildeten Stiften 68 in den Referenzöfmungen 24 der Leiterplatte 12 montiert wird, ist durch Bezugszeichen 70 gekennzeichnet.

Vor dem Fügen des zweiten Passungsteils 34 mit dem ersten Passungsteil 28 wird zunächst die das erste Passungsteil 28 an der Oberseite verschließende Membran 60 entfernt und bei der Montage des Gehäuses des Kameramoduls 10 das an diesem befestigte zweite Passungsteil 34 in die von der Membran 60 freigegebene Öffnung des ersten Passungsteils 28 eingeschoben. Die an der Außenfläche 40 des zweiten Passungsteils 34 verlaufende mindestens eine Leiterbahn 54 liegen somit an der Innenfläche 30 des ersten Passungsteils 28 an. Im zweiten Passungsteil 34 ist darüber hinaus das in Figur 3 schematisch angedeutete Objektiv 42 aufgenommen, oberhalb dessen im Gehäuse des Kameramoduls 10 die Öffnung 56 ausgebildet ist. Bevorzugt verläuft die mindestens eine Leiterbahn 54 an der Außenseite des zweiten Passungsteils 34 in Mäanderform 62, um eine größtmögliche Überdeckung zwischen dem ersten Passungsteil 28 und dem zweiten Passungsteil 34 zu erreichen. Des Weiteren geht aus Figur 3 hervor, dass an der Oberseite des Gehäuses des Kameramoduls 10 Kontaktierungen 64 verlaufen, mit denen die mindestens eine an der Außenfläche 40 des zweiten Passungsteiles 34 bevorzugt beschichtet aufgebrachte Leiterbahn 54 elektrisch kontaktiert wird.

Die als Tubus 52 fungierende Innenfläche 38 des zweiten Passungsteiles 34 nimmt das hier nur schematisch angedeutete Objektiv 42 auf. Das in Figur 3 dargestellte Objektiv 42, welches außer dem Objektiv 42 weitere, in Figur 2 angedeutete Linsen 44, 46 und 48 aufweisen kann, ist in dem Gehäuse des Kameramoduls 10 vormontiert. Dies eröffnet die Möglichkeit, Kameramodule 10 mit unterschiedlichen optischen Auslegungen mit jeweils identisch aufgebauten vormontierten und vorbestückten Leiterplatten 12 herzustellen.

Der Darstellung gemäß Figur 4 ist eine weitere Ausführungsvariante des erfindungsgemäß vorgeschlagenen Kameramoduls für Kfz-Anwendungen zu entnehmen.

Im Unterschied zur in Figur 3 dargestellten Explosionsdarstellung des erfindungsgemäß vorgeschlagenen Kameramoduls 10 sind gemäß dieser Ausführungsvariante sowohl das erste Passungsteil 28 als auch das zweite Passungsteil 34 von quadratischer Geometrie. Anstelle der in Figur dargestellten quadratischen Geometrie könnte auch eine rechteckige Geometrie oder eine andere Geometrie gewählt werden, wobei jeweils sicherzustellen ist, dass das erste Passungsteil 28 und das zweite Passungsteil 34 im gefügten Zustand den in Figur 2 dargestellten Überlappungsbereich 36 ausbilden, an dem, bewirkt durch die mindestens eine Leiterbahn 54, ein Anschmelzen oder Aufschmelzen des Kunststoffmaterials zur Ausbildung einer stoffschlüssigen Verbindung zwischen dem ersten Passungsteil 28 und dem zweiten Passungsteil 34 durchgeführt werden kann.

Gemäß der Ausführungsvariante in Figur 4 ist das obere Ende des zweiten Passungsteils 34 mit einer Abschlussplatte versehen, welche zur Öffnung 56 im Gehäuse des Kameramoduls 10 fluchtet. An dieser oder an in Figur 4 nicht näher dargestellten Einbauten innerhalb des zweiten Passungsteils 34 kann das Objektiv 42 nebst anderer Linsen im zweiten Passungsteil 34 fixiert werden. Wenn auch in den Figuren 3 und 4 als separates Bauteil dargestellt, kann das zweite Passungsteil 34 integral am Gehäuse des Kameramoduls 10, so z. B. an dessen Dachfläche, im Wege des Kunststoffspritzgießverfahrens einstückig ausgebildet werden.

Gemäß der Darstellung in Figur 4 verläuft die mindestens eine Leiterbahn 54, die über die Kontaktierungen 64 am Gehäuse des Kameramoduls 10 elektrisch kontaktiert wird, ebenfalls in Mäanderform 62 über die Rechteckseiten, d. h. die Außenflächen 40 des zweiten Passungsteils 34. Ebensogut wäre es möglich, die in Figur 4 an der Außenfläche 40 des zweiten Passungsteils 34 verlaufende mindestens eine Leiterbahn 54 an der Innenfläche 30 des ersten Passungsteils 28 anzuordnen. Auch für die in Figur 4 dargestellten Ausführungsvarianten des ersten und des zweiten Passungsteils 28, 34 gilt, dass die innerhalb des Überlappungsbereiches 36 aneinanderliegenden Oberflächenabschnitte texturiert ausgebildet werden können, so dass eine standfeste Verbindung mit minimaler Einwirkdauer und Leistung des Strompulses erreicht werden kann.

An der der Leiterplatte 12 zuweisenden Seite weist das erste Passungsteil 28 die bereits im Zusammenhang mit Figur 3 erwähnten Passstifte 68 auf, die in die Referenzöffhungen 24 der Leiterplatte 12 eingesteckt werden. Auch in der Darstellung gemäß Figur 4 umschließt das erste Passungsteil 28 im auf die Leiterplatte 12 aufgebrachten Zustand den auf der Leiterplatte kontaktierten Bildsensor-Chip 14. Zum Schutz des hochempfindlichen Bildarrays des Bildsensor-Chips 14 ist auch gemäß der in Figur 4 dargestellten Ausführungsvariante das offene Ende des ersten Passungsteils 28 mit einer Folie oder einer Membran 60 abgedeckt, um zu verhindern, dass Partikel auf die Oberfläche des Bildsensor-Chips 14 gelangen. Die Membran 60 beziehungsweise ein anderes geeignetes Abdeckmaterial wird erst von der Oberseite des ersten Passungsteils 28 entfernt, wenn das leiterplattenseitige erste Passungsteil 28 mit dem gehäuseseitigen zweiten Passungsteil 34 gefügt wird und nach Fokussierung zwischen dem Objektiv 42 und dem Bildsensor-Chip 14 die stoffschlüssige Verbindung zwischen dem ersten Passungsteil 28 und dem zweiten Passungsteil 34 durch Anschmelzen des Kunststoffes erfolgt. Unter Anschmelzen des Kunststoffmaterials in Zusammenhang mit dem ersten Passungsteil 28 und dem zweiten Passungsteil 34, seien sie hülsenförmig oder seien sie, wie in Figur 4, rechteckig oder quadratisch ausgebildet, wird verstanden, dass sowohl die Außenseiten 40 des zweiten Passungsteils 34. als auch die Innenfläche 30 des ersten Passungsteils 28 an- oder aufgeschmolzen werden können.

Bei den in Figur 3 und 4 dargestellten Montagevarianten mit in unterschiedlicher Geometrie ausgebildeten Passungsteilen 28, 34 erfolgt die Fokussierung mittels motorisierter automatisierter Einrichtungen, mit denen die beiden Teilbaugruppen, die mit dem ersten Passungsteil 28 versehene Leiterplatte 12 sowie das mit dem zweiten Passungsteil 34 versehene Gehäuse des Kameramoduls 10 ineinandergeschoben werden. Die Fokussierung der beiden Bauteile, d. h. des Gehäuses des Kameramoduls 10 und der vormontierten Leiteiplatte 12, erfolgt derart, dass die den Bilddaten während der Fokussierung ermittelten Kontrastwerte aufgenommener Test-Charts optimiert sind. Die Fokussierung erfolgt bei aktivem Betrieb des Bildsensor-Chips 14 durch Auswertung des Bilds eines entsprechenden Test-Charts. Die eingestellte Fokuslage wird durch die Aufgabe des Stromimpulses auf die mindestens eine Leiterbahn 54 an einer der beiden Passungsteile 28, 34 bewirkt, was einen möglichst schnellen Prozessschritt zur Fixierung der optimalen Fokuslage von Objektiv 42 in Bezug auf den Bildsensor-Chip 14 ermöglicht.

Das vorstehend in Zusammenhang mit den Figuren 1 bis 4 beschriebene Kameramodul 10 erlaubt den Einsatz eines Bildsensorchips 14, der mittels eines videounterstützten Die-Bonding-Prozesses direkt mit hoher Präzision zu den Referenzöffnungen 24 in der Leiterplatte 12 positioniert werden kann. Ablagefehler, die bei in separaten Gehäusen aufgenommenen Bildsensoren entstehen, werden durch die erfindungsgemäß vorgeschlagene Lösung ausgeschlossen. Daneben kann das leiterplattenseitige Passungsteil, d. h. im vorliegenden Falle das erste Passungsteil 28, passgenau zu den Referenzöffnungen 24 ausgerichtet werden und dort nach Verstiftung mittels einer stoffschlüssigen Verbindung verklebt werden.

Erfolgt die Anbindung der Leiterplatte 12 an den gehäuseseitigen Stecker mit einer flexiblen Lösung, wie z. B. durch das flexible Kabelende 66, können Spannungsbelastungen in der Leiterplatte 12 durch Mehrfacheinspannung vermieden werden. Bevorzugt werden das erste Passungsteil 28 sowie das zweite Passungsteil 34 in einem für die optischen Anforderungen geeigneten Material angefertigt werden, so dass z. B. ausreichend niedrige Reflexionswerte auftreten und das Risiko optischer Störungen durch Streulicht begrenzt bleibt. Das Objektiv 42 wird dicht in das Gehäuse des Kameramoduls 10 montiert, so dass kein anschließender Abdichtungsschritt mehr erforderlich ist. Des Weiteren erlaubt das erfindungsgemäß vorgeschlagene Montageverfahren die Fixierung einer genau eingestellten Fokuslage zwischen dem Objektiv 42 und dem Bildsensor-Chip 14. Die genau eingestellte Fokuslage kann durch den elektrisch steuerbaren, lokalen Aufschmelz- beziehungsweise Anschmelzprozess zur Ausbildung einer stoffschlüssigen Verbindung zwischen dem ersten Passungsteil 28 und dem zweiten Passungsteil 34 schnell ausgeführt werden. Gegenüber dem Laserschweißen oder UV-Härtung entstehen keine Probleme, die für die Aktivierung der stoffschlüssigen Verbindung erforderliche Energie an die mindestens eine Leiterbahn 54 abzuführen. Hinsichtlich einer Serienfertigung ist von Vorteil, dass für Kameramodule 10 mit unterschiedlicher optischer Auslegung, jedoch gleichem elektronischen Aufbau ein und dieselbe vormontierte und bestückte Leiterplatte 12 verwendet werden kann und lediglich die Gehäuse der Kameramodule 10 angepasst an das jeweils aufzunehmende Objektiv 42 für die jeweilige Anwendung anwendungsspezifisch ausgeführt werden müssen.

## Patentansprüche

1. Verfahren zur Herstellung eines Kameramoduls (10), ein Objektiv (42) und einen Bildsensor-Chip (14) umfassend, wobei der Bildsensor-Chip (14) mit einer Leiterplatte (12) kontaktiert ist, mit nachfolgenden Verfahrensschritten:
a) dem Positionieren und Befestigen eines den Bildsensor-Chip (14) umgebenden, ersten Passungsteils (28) auf der Leiterplatte (12),
b) dem Fügen des ersten Passungsteils (28) mit einem am Gehäuse des Kameramoduls (10) angeordneten zweiten Passungsteil (34) unter Ausbildung eines Überlappungsbereichs (36),
c) der Herstellung einer Fokuslage zwischen dem gehäuseseitigen Objektiv (42) und dem Bildsensor-Chip (14) und
d) der Erzeugung einer stoffschlüssigen Verbindung zwischen den Passungsteilen (28, 34) innerhalb des Überlappungsbereichs (36) in der Fokuslage gemäß Verfahrensschritt c), wobei mindestens eines der Passungsteile durch lokale Erwärmung in einem begrenzten Bereich aufgeschmolzen wird durch Leiten von Strom durch eine Leiterbahn, die auf dem mindestens einen Passungsteil aufgebracht ist.

2. Verfahren gemäß Anspruch 1, **dadurch gekennzeichnet, dass** gemäß Verfahrensschritt a) das erste Passungsteil (28) innerhalb eines Aufsetzbereichs (22) mit der Leiterplatte (12) verstiftet wird.

3. Verfahren gemäß Anspruch 1, **dadurch gekennzeichnet, dass** gemäß Verfahrensschritt a) zwischen dem ersten Passungsteil (28) und der Leiterplatte (12) eine stoffschlüssige Verbindung hergestellt wird.

4. Verfahren gemäß Anspruch 1, **dadurch gekennzeichnet, dass** gemäß Verfahrensschritt b) die Ermittlung der Fokuslage von Objektiv (42) und Bildsensor-Chip (14) entlang der optischen Achse erfolgt, der Bildsensor-Chip (14) für eine Bildauswertung elektrisch kontaktiert ist und das Gehäuse des Kameramoduls (10) und die Leiterplatte (12) motorisch zueinander ausgerichtet werden.

5. Verfahren gemäß Anspruch 1, **dadurch gekennzeichnet, dass** nach Verfahrensschritt a) eine Abdeckung (60) auf das den Bildsensor-Chip (14) umgebende erste Passungsteil (28) aufgebracht wird, die vor Durchführung des Verfahrensschrittes b) entfernt wird.

6. Verfahren gemäß Anspruch 1, **dadurch gekennzeichnet, dass** gemäß Verfahrensschritt d) über mindestens eine Leiterbahn (54) an mindestens einem der Passungsteile (28, 34) ein Anschmelzen des Materials der Passungsteile (28, 34) erfolgt.

7. Kameramodul (10) mit einem ein Objektiv (42) aufnehmenden Gehäuse und einer mit einem Bildsensor-Chip (14) kontaktierten Leiterplatte (12), **dadurch gekennzeichnet, dass** die Leiterplatte (12) und das Gehäuse des Kameramoduls (10) über eine stoffschlüssige Verbindung innerhalb eines Überlappungsbereiches (36) zwischen einem ersten, gehäuseseitigen Passungsteil (28) und einem zweiten, leiterplattenseitigen Passungsteil (34) verbunden sind, wobei mindestens eines der Passungsteile mit einer Leiterbahn beschichtet ist, die bei Bestromung zum Aufschmelzen eines begrenzten Bereichs des Passungsteils eingerichtet ist.

8. Kameramodul (10) gemäß Anspruch 7, **dadurch gekennzeichnet, dass** die Passungsteile (28, 34) in zueinander komplementärer Geometrie, hülsenförmig, rechteckförmig oder quadratisch ausgeführt sind.

9. Kameramodul (10) gemäß Anspruch 7, **dadurch gekennzeichnet, dass** mindestens eine elektrisch kontaktierbare Leiterbahn (54) an mindestens einem der Passungsteile (28, 34) verläuft.

10. Kameramodul (10) gemäß Anspruch 9, **dadurch gekennzeichnet, dass** die mindestens eine Leiterbahn (54) an der Außenfläche (40) des in das erste Passungsteil (28) hineinragenden zweiten Passungsteils (34) oder an der Innenfläche (30) des das zweite Passungsteil (34) umschließenden ersten Passungsteils (28) ausgebildet ist.

## Claims

1. Method for producing a camera module (10), comprising a lens (42) and an image sensor chip (14), wherein the image sensor chip (14) is contact-connected to a printed circuit board (12), comprising the following method steps:
a) positioning and fixing a first fitting part (28), which surrounds the image sensor chip (14), on the printed circuit board (12),
b) joining the first fitting part (28) to a second fitting part (34) which is arranged on the housing of the camera module (10), with the formation of an overlap region (36),
c) producing a focus position between the housing-side lens (42) and the image sensor chip (14), and
d) creating a cohesive connection between the fitting parts (28, 34) within the overlap region (36) at the focus position in accordance with method step c), wherein at least one of the fitting parts is melted on in a delimited region by local heating, by conducting current through a conductor track applied on the at least one fitting part.

2. Method according to Claim 1, **characterized in that**, in accordance with method step a), the first fitting part (28) is pinned to the printed circuit board (12) within a placement region (22).

3. Method according to Claim 1, **characterized in that**, in accordance with method step a), a cohesive connection is produced between the first fitting part (28) and the printed circuit board (12).

4. Method according to Claim 1, **characterized in that**, in accordance with method step b), the focus position of lens (42) and image sensor chip (14) is determined along the optical axis, the image sensor chip (14) is electrically contact-connected for image evaluation, and the housing of the camera module (10) and the printed circuit board (12) are aligned with one another in motorized fashion.

5. Method according to Claim 1, **characterized in that** after method step a), a covering (60) is applied to the first fitting part (28) surrounding the image sensor chip (14), said covering being removed before method step b) is carried out.

6. Method according to Claim 1, **characterized in that**, in accordance with method step d), via at least one conductor track (54) on at least one of the fitting parts (28, 34), the material of the fitting parts (28, 34) is melted.

7. Camera module (10) comprising a housing accommodating a lens (42), and comprising a printed circuit board (12) contact-connected to an image sensor chip (14), **characterized in that** the printed circuit board (12) and the housing of the camera module (10) are connected via a cohesive connection within an overlap region (36) between a first, housing-side fitting part (28) and a second, printed-circuit-board-side fitting part (34), wherein at least one of the fitting parts is coated with a conductor track designed for melting on a delimited region of the fitting part upon conducting current.

8. Camera module (10) according to Claim 7, **characterized in that** the fitting parts (28, 34) are embodied with mutually complementary geometry, in sleeve-shaped fashion, in rectangular fashion or in square fashion.

9. Camera module (10) according to Claim 7, **characterized in that** at least one electrically contact-connectable conductor track (54) runs on at least one of the fitting parts (28, 34).

10. Camera module (10) according to Claim 9, **characterized in that** the at least one conductor track (54) is formed on the outer surface (40) of the second fitting part (34) projecting into the first fitting part (28), or on the inner surface (30) of the first fitting part (28) enclosing the second fitting part (34).

## Revendications

1. Procédé de fabrication d'un module de caméra (10) comprenant un objectif (42) et une puce (14) de détection d'image, la puce (14) de détection d'image étant mise en contact avec une carte de circuit (12), le procédé comportant les étapes suivantes :
a) placement et fixation sur la carte de circuit (12) d'une première pièce d'adaptation (28) qui entoure la puce (14) de détection d'image,
b) jonction de la première pièce d'adaptation (28) avec une deuxième pièce d'adaptation (34) disposée sur le boîtier du module de caméra (10) en formant une zone de superposition (36),
c) établissement d'une position de foyer entre l'objectif (42) situé du côté du boîtier et la puce (14) de détection d'image et
d) formation d'une liaison en correspondance de matière entre les pièces d'adaptation (28, 34) à l'intérieur de la zone de superposition (36) dans la position de foyer de l'étape c),
au moins l'une des pièces d'adaptation étant fondue par échauffement local dans une partie limitée en amenant du courant par une piste conductrice appliquée sur au moins une pièce d'adaptation.

2. Procédé selon la revendication 1, **caractérisé en ce que** dans l'étape a) du procédé, la première pièce d'adaptation (28) est enfichée sur la carte de circuit (12) à l'intérieur d'une partie de contact (22).

3. Procédé selon la revendication 1, **caractérisé en ce que** dans l'étape a) du procédé, une liaison en correspondance de matière est établie entre la première pièce d'adaptation (28) et la carte de circuit (12).

4. Procédé selon la revendication 1, **caractérisé en ce que** dans l'étape b) du procédé, la détermination de la position de foyer de l'objectif (42) et de la puce (14) de détection d'image s'effectue le long de l'axe optique, la puce (14) de détection d'image étant mise en contact électrique en vue d'une évaluation d'image, le boîtier du module de caméra (10) et la carte de circuit (12) étant alignés mutuellement à l'aide d'un moteur.

5. Procédé selon la revendication 1, **caractérisé en ce qu'**après l'étape a) du procédé, un couvercle (60) est appliqué sur la première pièce d'adaptation (28) qui entoure la puce (14) de détection d'image et est enlevé avant la réalisation de l'étape b) du procédé.

6. Procédé selon la revendication 1, **caractérisé en ce que** dans l'étape d), le matériau des pièces d'adaptation (28, 34) est fondu à l'aide d'au moins une piste conductrice (54) prévue sur au moins l'une des pièces d'adaptation (28, 34).

7. Module de caméra (10) doté d'un boîtier qui reprend un objectif (42) et d'une carte de circuit (12) mise en contact avec une puce (14) de détection d'image,
**caractérisé en ce que**
la carte de circuit (12) et le boîtier du module de caméra (10) sont reliés par une liaison en correspondance de matière à l'intérieur d'une zone de superposition (36) entre une première pièce d'adaptation (28) située du côté du boîtier et une deuxième pièce d'adaptation (34) située du côté de la carte de circuit, au moins l'une des pièces d'adaptation étant revêtue d'une piste conductrice qui est destinée à faire fondre une partie limitée de la pièce d'adaptation par apport d'un courant.

8. Module de caméra (10) selon la revendication 7, **caractérisé en ce que** les pièces d'adaptation (28, 34) sont réalisées dans des géométries mutuellement complémentaires, en forme de douille, de rectangle ou de carré.

9. Module de caméra (10) selon la revendication 7, **caractérisé en ce qu'**au moins une piste conductrice (54) apte à être mise en contact électrique s'étend sur au moins l'une des pièces d'adaptation (28, 34).

10. Module de caméra (10) selon la revendication 9, **caractérisé en ce que** la ou les pistes conductrices (54) sont formées sur la surface extérieure (40) de la deuxième pièce d'adaptation (34) qui s'enfonce dans la première pièce d'adaptation (28) ou sur une surface intérieure (30) de la première pièce d'adaptation (28) qui entoure la deuxième pièce d'adaptation (34).
